# EUROPEAN PATENT SPECIFICATION

(11) **EP 3 705 897 B1**
(45) Date of publication and mention of the grant of the patent: **14.06.2023**
(21) Application number: 18874195.3
(22) Date of filing: 06.09.2018
(51) Int. Cl.: G01R 19/165, H05K 1/02, H05K 1/18

(54) **CURRENT DETECTION DEVICE**
STROMERKENNUNGSVORRICHTUNG
DISPOSITIF DE DÉTECTION DE COURANT

(30) Priority: 30.10.2017 JP 2017209118
(43) Date of publication of application: 09.09.2020
(73) Proprietor: Daikin Industries, Ltd., Osaka-shi, Osaka 530-0001 (JP)
(72) Inventor: YAMADA Eisuke, Osaka-Shi Osaka 530-8323 (JP); TAKIGUCHI Naoya, Osaka-Shi Osaka 530-8323 (JP); YAMADA Toshiyuki, Osaka-Shi Osaka 530-8323 (JP)
(74) Representative: Hoffmann Eitle
(86) International application number: PCT/JP2018/033006
(87) International publication number: WO 2019/087566

(56) References cited:
- EP-A2- 1 130 950
- WO-A1-2007/080748
- JP-A- H06 112 613
- JP-A- S61 272 481
- JP-A- 2002 034 264
- JP-A- 2002 291 260
- JP-A- 2003 264 354
- JP-A- 2008 016 770
- JP-A- 2008 130 612
- JP-A- 2010 017 039
- JP-A- 2014 521 935
- JP-A- 2016 100 929
- JP-A- 2016 100 929
- US-A1- 2014 035 497

## Description

The present disclosure relates to a current detection device.

Japanese Patent Application Laid-Open No. 2016-8829 describes a vehicle warning light control circuit. This circuit includes a warning light, a primary coil connected in series to the warning light, a secondary coil that forms a transformer with the primary coil, and a current detection unit that detects a current flowing through the secondary coil.

Japanese Patent Application Laid-Open No. 2016-100929 A describes an inverter control device comprising a multilayer circuit board having a laminated structure and an inverter mounted on the circuit board. United States application publication no. US 2014/035,497 A1 describes a filter for reducing emissions in switching power converters, such as a motor drive. However, neither publication discloses the combination of features set forth in Claim 1 below.

The invention provides a current detection device comprising: a multilayer board including a first surface provided for mounting a power module, the power module having switching elements, the multilayer board further including a second surface on an opposite side of the multilayer board to the first surface, a first wiring layer in the first surface, a second wiring layer arranged on a side nearer to the second surface than the first wiring layer, a third wiring layer arranged on the side nearer to the second surface than the second wiring layer; a current detection unit that is mounted on the first surface, for detecting a current flowing through the power module, and for outputting a detection signal; and a control unit that is mounted on the first surface and for receiving the detection signal, characterized by further comprising: a detection wire for transmitting the detection signal from the current detection unit to the control unit, and having a first wiring portion extending from the current detection unit to the third wiring layer, a second wiring portion connected to the first wiring portion and formed in the third wiring layer, and a third wiring portion connected to the second wiring portion and extending from the third wiring layer to the control unit; and a first conductor arranged in the second wiring layer between the second wiring portion of the detection wire and the power module, and applied with a fixed potential, the multilayer board further including a fourth wiring layer in the second surface; a first insulating layer arranged between a set of inner wiring layers and the first wiring layer, the set being positioned between the first wiring layer and the fourth wiring layer, the set including the second wiring layer and the third wiring layer; at least one second insulating layer arranged between adjacent ones of the inner wiring layers; and a third insulating layer arranged between the set and the fourth wiring layer, configured such that, a comparative tracking index of the first insulating layer is higher than a comparative tracking index of any of the second insulating layers, and a comparative tracking index of the third insulating layer is higher than the comparative tracking index of any of the second insulating layers.

In the current detection device according to this aspect, a detection signal with low noise can be input to the control unit, the accuracy of current detection thus being improved whilst manufacturing costs are reduced as compared with the case of adopting an insulating layer having a high comparative tracking index as the second insulating layer.

In an embodiment, the current detection device has the first conductor facing either or both of the second wiring portion of the detection wires and the power module, in a thickness direction of the multilayer board.

In the current detection device according to this embodiment, the first conductor easily shields noise propagated from the power module to the wiring portion.

In an embodiment, the power module is positioned in the first surface of the multilayer board between the current detection unit and the control unit

In the current detection device according to this embodiment, the second wiring portion of the detection wires is easily arranged to face the power module.

In an embodiment, there is further included a second conductor formed at a position in the third wiring layer adjacent to the second wiring portion of the detection wires without interposing another wire, and applied with a fixed potential.

In the current detection device according to this embodiment, the second conductor can shield noise propagated from another wire formed in the third wiring layer to the detection wires.

In a further embodiment, a maximum value of a voltage is applied to wires formed in the first wiring layer and a maximum value of a voltage is applied to wires formed in the fourth wiring layer and are larger than a maximum value of a voltage applied to wires formed in any of the inner wiring layers.

In the current detection device according to this embodiment, the comparative tracking index of the second insulating layer is low and the comparative tracking indices of the first insulating layer and the third insulating layer are high.

In another embodiment, a minimum value of a gap between wires formed in the first wiring layer and a minimum value of a gap between wires formed in the fourth wiring layer are smaller than a minimum value of a gap between wires formed in any of the inner wiring layers.

In the current detection device according to this embodiment, the comparative tracking index of the second insulating layer is low and the comparative tracking indices of the first insulating layer and the third insulating layer are high.

In order that the invention will be more readily understood, embodiments thereof will now be described, by way of example only, with reference to the drawings, and in which: -
Fig. 1 is a diagram schematically showing an example of an electrical configuration of a current detection device;
Fig. 2 is a cross-sectional view schematically showing an example of a mechanical configuration of the current detection device;
Fig. 3 is a plan view schematically showing an example of the mechanical configuration of the current detection device;
Fig. 4 is a diagram for explaining an example of a positional relationship of a power module, a conductor, and a wiring portion; and
Fig. 5 is a cross-sectional view schematically showing an example of a mechanical configuration of a current detection device.

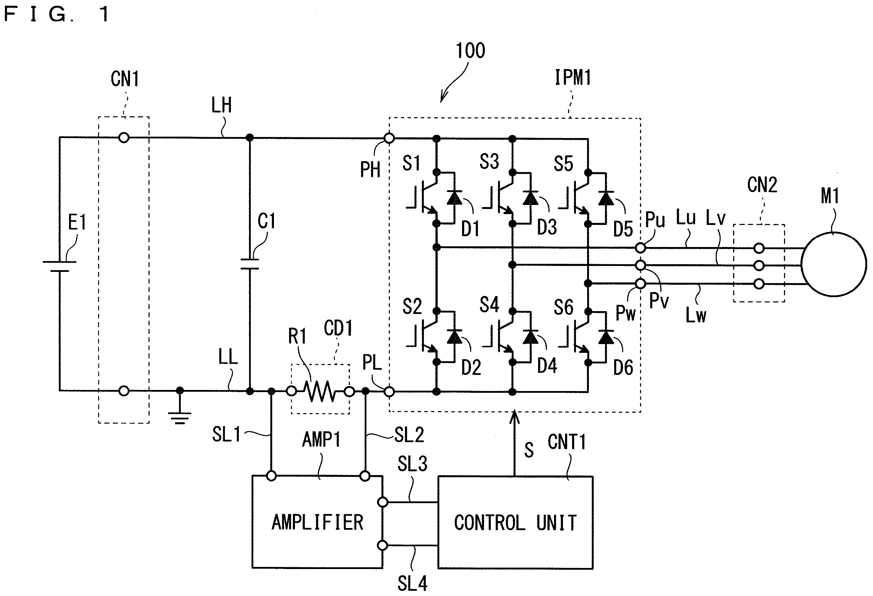

Fig. 1 is a diagram schematically showing an example of an electrical configuration of a current detection device 100. The current detection device 100 includes a current detection unit CD1 and a control unit CNT1. The current detection device 100 is a device that detects a current flowing through a power module IPM1. The power module IPM1 is, for example, an intelligent power module. The power module IPM1 has switching elements and has, for example, a power conversion function. In the example of Fig. 1, the power module IPM1 has an inverter. Specifically, the power module IPM1 has input terminals PH and PL, switching elements S1 to S6, diodes D1 to D6, and output terminals Pu, Pv, and Pw.

A DC voltage is applied between the input terminals PH and PL. Here, a potential applied to the input terminal PH is higher than a potential applied to the input terminal PL. One ends of DC power source lines LH and LL are connected to the input terminals PH and PL, respectively. In the example of Fig. 1, a capacitor C1 is connected between the DC power source lines LH and LL. A capacitance of the capacitor C1 may be large enough to smooth the DC voltage between the DC power source lines LH and LL, or small enough to cause the DC voltage to pulsate.

In the example of Fig. 1, a connector CN1 is provided. The connector CN1 is connected to the other ends of the DC power source lines LH and LL. Further, a DC power source E1 is connected to the connector CN1. The DC power source E1 applies the DC voltage between the DC power source lines LH and LL via the connector CN1. This DC voltage is, for example, about several hundred (e.g., 280) volts.

The switching elements S1 to S6 are, for example, transistors such as insulated gate bipolar transistors. The switching elements S1 and S2 are connected in series between the input terminals PH and PL, and the switching elements S3 and S4 are connected in series between the input terminals PH and PL, and the switching elements S5 and S6 are connected in series between the input terminals PH and PL. A set of switching elements S1 and S2, a set of switching elements S3 and S4, and a set of switching elements S5 and S6, are connected to each other in parallel.

The diodes D1 to D6 are connected in parallel to the switching elements S1 to S6, respectively, and all of forward directions thereof are directions directed from the input terminal PL to the input terminal PH.

A connection point connecting the switching elements S1 and S2 to each other is connected to the output terminal Pu, a connection point connecting the switching elements S3 and S4 to each other is connected to the output terminal Pv, and the connection point connecting the switching elements S5 and S6 to each other is connected to the output terminal Pw.

The power module IPM1 converts the DC voltage between the input terminals PH and PL into a three-phase AC voltage by operation of the switching elements S1 to S6, and outputs the three-phase AC voltage from the output terminals Pu, Pv and Pw.

In the example of Fig. 1, a connector CN2 is provided. The connector CN2 is connected to the output terminals Pu, Pv, and Pw of the power module IPM1 via output lines Lu, Lv, Lw, respectively. Additionally, a load M1 is connected to the connector CN2. The load M1 is, for example, a three-phase motor, and rotates according to the three-phase AC voltage from the power module IPM1.

The current detection unit CD1 detects a current flowing through the power module IPM1, and outputs a detection signal indicating a magnitude of the current. In the example of Fig. 1, the current detection unit CD1 is provided on the DC power source line LL to detect a current flowing through the input terminal PL. In the example of Fig. 1, the current detection unit DC1 has a resistor R1. This resistor R1 is provided on the DC power source line LL. The current detection unit DC1 outputs a voltage across the resistor R1 as a detection signal. That is, the resistor R1 functions as a so-called shunt resistor.

As a resistance value of the resistor R1 gets smaller, the power consumption of the resistor R1 can be reduced further. In this case, the voltage across the resistor R1 gets smaller. The voltage across the resistor R1 varies in a range of, for example, about zero volts to about several tens of volts or less according to the magnitude of the current. Therefore, as illustrated in Fig. 1, the current detection device 100 may be provided with an amplifier AMP1. The amplifier AMP1 receives a detection signal from the current detection unit CD1 via detection wires SL1 and SL2. Specifically, the detection wire SL1 connects one end of the resistor R1 and the amplifier AMP1 to each other, and the detection wire SL2 connects the other end of the resistor R1 and the amplifier AMP1 to each other. As a result, the voltage across the resistor R1 is input to the amplifier AMP1 as the detection signal. The amplifier AMP1 amplifies the input detection signal, and outputs the amplified detection signal to the control unit CNT1 via detection wires SL3 and SL4.

The control unit CNT1 receives the detection signal via the detection wires SL1 to SL4. It can be said that the detection wires SL1 to SL4 are wires for transmitting a detection signal from the current detection unit CD1 to the control unit CNT1. The control unit CNT1 generates a control signal S for controlling the switching elements S1 to S6 of the power module IPM1 based on the detection signal, and outputs the control signal S. More specifically, a command value for the load M1 (for example, a command value for rotational speed of the motor) externally input to the control unit CNT1, and the control unit CNT1 generates a control signal S based on the command value and the detection signal. The generation itself as such of the control signal S can be realized by a known technique, and is not the essence of the present application, and thus a detailed description is omitted.

Here, the control unit CNT1 is constituted by including a microcomputer and a storage device. The microcomputer executes each processing step (in other words, procedure) described in a program. The storage device can be constituted of one or more of various storage devices such as a read only memory (ROM), a random access memory (RAM), and a rewritable nonvolatile memory such as an erasable programmable ROM (EPROM). The storage device stores various information, data, and the like, stores a program executed by the microcomputer, and provides a work area for executing the program. The microcomputer can be understood to function as various means corresponding to each processing step described in the program, or can be understood to realize various functions corresponding to each processing step. The control unit CNT1 is not limited to this, and various procedures executed by the control unit CNT1, or some or all of the means or various functions realized thereby may be realized by hardware.

Also, a set of the power module IPM1 and the current detection device 100 can be said to be a load driving device because the set can drive the load M1. This load driving device is mounted on, for example, an air conditioner. When the load driving device is mounted on, for example, an indoor unit of the air conditioner, a fan motor mounted on the indoor unit may be adopted as the load M1.

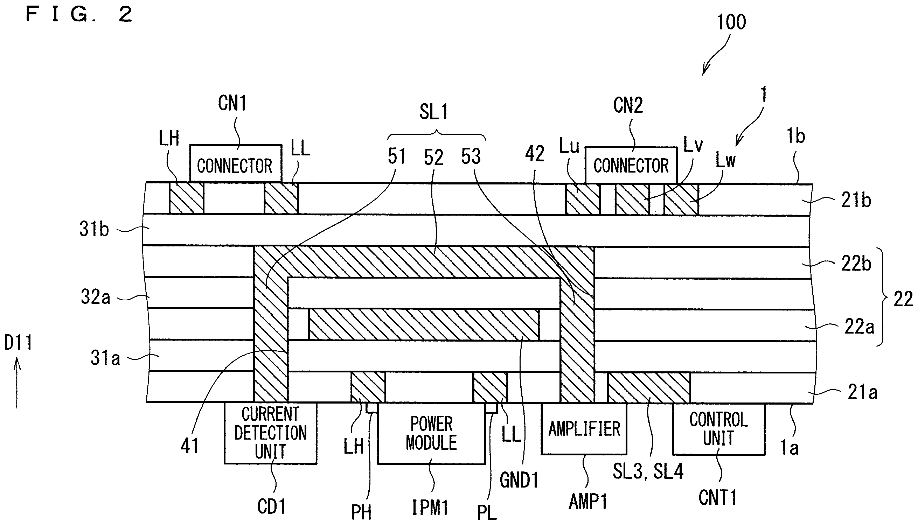

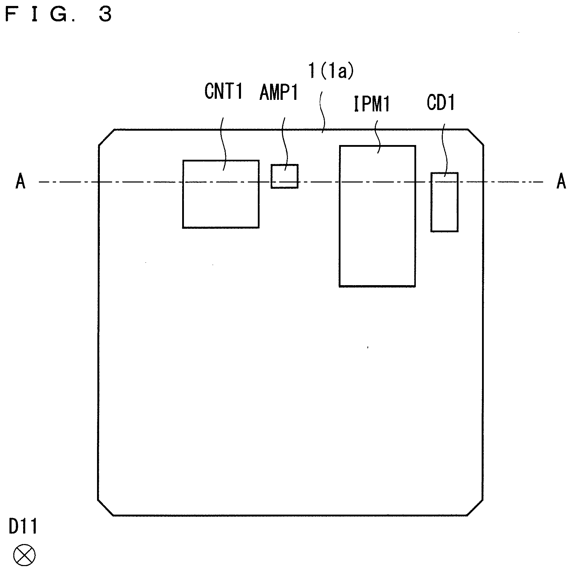

Fig. 2 and Fig. 3 are a cross-sectional view and a plan view schematically showing an example of a mechanical configuration of the current detection device 100, respectively. Fig. 2 is a cross section taken along a line A-A of Fig. 3. The current detection device 100 has a multilayer board 1. The multilayer board 1 is a plate-shaped form, and Fig. 2 illustrates a cross section including a thickness direction D11 thereof. Fig. 3 is a plan view viewed planarly along the thickness direction D11.

The multilayer board 1 has a first surface 1a, and a second surface 1b on an opposite side to the first surface 1a. The first surface 1a and the second surface 1b face each other in the thickness direction D11. When one of the first surface 1a and the second surface 1b is regarded as a front surface, the other is regarded as the rear surface.

The multilayer board 1 is a so-called printed wiring board, and has three or more wiring layers. Fig. 2 illustrates a four-layer board having four wiring layers as the multilayer board 1. More specifically, the multilayer board 1 has wiring layers 21a, 21b, 22a, and 22b, and insulating layers 31a, 31b, and 32a. The wiring layer 21a is arranged in the first surface 1a, the wiring layer 22a is arranged on a side nearer to the second surface 1b than the wiring layer 21a, and the wiring layer 22b is arranged on the side nearer to the second surface 1b than the wiring layer 22a. The wiring layer 21b is arranged nearer to the second surface 1b than the wiring layer 22b, and more specifically, is arranged in the second surface 1b.

According to the above structure, the wiring layers 21a and 21b are arranged on both sides of the multilayer board 1 in the thickness direction D11, and the wiring layers 22a and 22b are arranged between the wiring layers 21a and 21b. Therefore, hereinafter, the wiring layers 21a and 21b are also referred to as outer wiring layers 21a and 21b, respectively, and the wiring layers 22a and 22b are also referred to as inner wiring layers 22a and 22b, respectively. Further, a set of the inner wiring layers 22a and 22b is also referred to as an inner wiring layer set 22.

The insulating layer 31a is arranged between the outer wiring layer 21a and the inner wiring layer set 22, and insulates between the outer wiring layer 21a and the inner wiring layer 22a. More specifically, the insulating layer 31a is arranged between the outer wiring layer 21a and the inner wiring layer 22a, and is in contact with the outer wiring layer 21a and the inner wiring layer 22a. The insulating layer 32a is arranged between the inner wiring layers 22a and 22b, and insulates between the inner wiring layers 22a and 22b. The insulating layer 32a is in contact with the inner wiring layers 22a and 22b. The insulating layer 31b is arranged between the inner wiring layer set 22 and the outer wiring layer 21b, and insulates between the inner wiring layer 22b and the outer wiring layer 21b. More specifically, the insulating layer 31b is arranged between the inner wiring layer 22b and the outer wiring layer 21b, and is in contact with the inner wiring layer 22b and the outer wiring layer 21b. For example, the insulating layers 31a, 31b, and 32a are formed by melting and curing a sheet called a so-called prepreg.

Because the insulating layers 31a and 31b are positioned on the outer sides in the multilayer board 1 with respect to the insulating layer 32a, the insulating layers 31a and 31b are hereinafter also referred to as outer insulating layers 31a and 31b, respectively, and the insulating layer 32a is also referred to as an inner insulating layer 32a.

Wires (for example, copper wires) are appropriately formed on each of the wiring layers 21a, 21b, 22a, and 22b. For example, the respective wiring layers 21a, 21b, 22a, and 22b, various types of wires are formed by etching a metal plate member (for example, a copper foil). Further, through-holes are appropriately formed in the multilayer board 1, and the wires of the respective wiring layers are appropriately connected. The through-holes as such are formed by appropriately etching the wiring layers 21a, 21b, 22a, and 22b, and the insulating layers 31a, 31b, and 32a. Hereinafter, the above-described various electric components are described together with a specific example of the wires.

The first surface 1a of the multilayer board 1 is provided for mounting the power module IPM1. The current detection unit CD1, the amplifier AMP1, and the control unit CNT1 are mounted on the first surface 1a, and the connectors CN1 and CN2 are mounted on the second surface 1b of the multilayer board 1. The connectors CN1 and CN2, the power module IPM1, the current detection unit DC1, the amplifier AMP1, and the control unit CNT1 are, for example, surface mount components. If these components are surface mount components, the components are mounted on the multilayer board 1 by, for example, reflow soldering.

The DC power source lines LH and LL to be connected to the input terminals PH and PL of the power module IPM1, respectively, are formed in the outer wiring layer 21a. The DC power source lines LH and LL extend from the outer wiring layer 21a to the outer wiring layer 21b via through-holes (not shown) formed in the multilayer board 1, and are connected to the connector CN1 at the outer wiring layer 21b.

Although not shown in Fig. 2, the output lines Lu, Lv, and Lw to be connected to the output terminals Pu, Pv, and Pw of the power module IPM1, respectively, are formed in the outer wiring layer 21a. These output lines Lu, Lv, and Lw respectively extend from the outer wiring layer 21a to the outer wiring layer 21b via through-holes (not shown) formed in the multilayer board 1, and are connected to the connector CN2 at the outer wiring layer 21b.

As shown in Fig. 2, the detection wire SL1 connects the current detection unit CD1 to the amplifier AMP1 via the inner wiring layer 22b. Specifically, the detection wire SL1 has wiring portions 51 to 53. The wiring portion 51 is connected to the current detection unit CD1 in the outer wiring layer 21a, and extends from the outer wiring layer 21a to the inner wiring layer 22b. As illustrated in Fig. 2, a through-hole 41 extending from the outer wiring layer 21a to the inner wiring layer 22b is formed in the multilayer board 1, and the wiring portion 51 extends from the outer wiring layer 21a to the inner wiring layer 22b via this through-hole 41.

The wiring portion 52 is formed in the inner wiring layer 22b and is connected to the wiring portion 51. The wiring portion 53 is connected to the wiring portion 52, extends from the inner wiring layer 22b to the outer wiring layer 21a, and is connected to the amplifier AMP1 at the outer wiring layer 21a. As illustrated in Fig. 2, a through-hole 42 extending from the inner wiring layer 22b to the outer wiring layer 21a is formed in the multilayer board 1, and the wiring portion 53 extends from the inner wiring layer 22b to the outer wiring layer 21a via the through hole 42.

The detection wire SL2 is similar to the detection wire SL1. That is, the detection wire SL2 also connects the current detection unit CD1 and the amplifier AMP1 via the inner wiring layer 22b. In other words, the detection wire SL2 also has wiring portions similar to the wiring portions 51 to 53.

In this way, by the detection wires SL1 and SL2 passing through the inner wiring layer 22b, an area of a region required in the outer wiring layer 21a for connecting the current detection unit CD1 and the amplifier AMP1 can be reduced. Therefore, an area of the multilayer board 1 can be reduced as compared with a board in which the detection wires SL1 and SL2 are arranged only in the outer wiring layer 21a. In other words, the current detection device 100 can be realized with a small size.

The detection wires SL3 and SL4 for connecting the amplifier AMP1 and the control unit CNT1 are formed in the outer wiring layer 21a.

A conductor GND1 to which a fixed potential is applied is formed in the inner wiring layer 22a located between the outer wiring layer 21a and the inner wiring layer 22b. The conductor GND1 is a type of wire, and is formed by etching a metal plate member (for example, copper foil). A ground potential can be adopted as the fixed potential. In other words, the conductor GND1 can be grounded. The conductor GND1 may be a linear ground pattern or a plate-shaped ground plane.

The conductor GND1 is positioned between each of the detection wires SL1 and SL2 and the power module IPM1. As a more specific example, the conductor GND1 mutually faces with both of a part of the wiring portion 52 of the detection wire SL1 and the power module IPM1 in the thickness direction D11. It is preferable that the conductor GND1 has a size so as to face substantially all or most of the power module IPM1 in plan view.

In the example of Fig. 3, the current detection unit CD1, the power module IPM1, the amplifier AMP1, and the control unit CNT1 are arranged in this order in plan view. That is, the power module IPM1 is positioned on the first surface 1a of the multilayer board 1 between the current detection unit CD1 and a pair of the amplifier AMP1 and the control unit CNT1.

According to the above positional relationship, the detection wires SL1 and SL2 can be easily formed so as to straddle the power module IPM1. In other words, the detection wire SL1 can be easily formed such that the wiring portion 52 faces the power module IPM1 in the thickness direction D11. The same applies to the detection wire SL2. In this structure, by forming the conductor GND1 between the wiring portion 52 and the power module IPM1, the wiring portion 52, the conductor GND1, and the power module IPM1 face each other in the thickness direction D11.

The power module IPM1 propagates noise to surroundings due to switching of the switching elements S1 to S6. That is, the power module IPM1 becomes a noise radiation source.

However, in the current detection device 100, the conductor GND1 to which the fixed potential is applied is positioned between each of the wiring portions 52 of the detection wires SL1 and SL2 and the power module IPM1. Therefore, noise from the power module IPM1 is shielded by the conductor GND1 and is less likely to propagate to the wiring portion 52. Therefore, the noise unlikely appears in the detection signals flowing through the detection wires SL1 and SL2. Therefore, a detection signal with low noise can be input to the amplifier AMP1. As a result, a detection signal with low noise can be input to the control unit CNT1.

In the example of Fig. 2, each of the wiring portions 52 of the detection wires SL1 and SL2, the conductor GND1, and the power module IPM1 face each other in the thickness direction D11. However, the above facing arrangement is not essential. Although the effect of suppressing the propagation of noise is reduced, each of the wiring portions 52 of the detection wires SL1 and SL2, the conductor GND1, and the power module IPM1 may be shifted from each other.

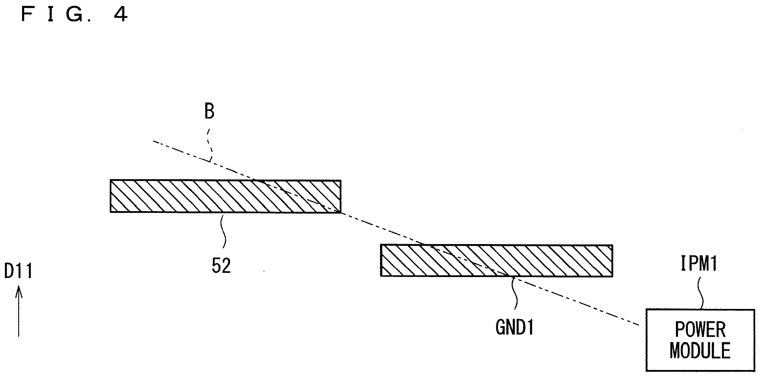

Fig. 4 is a diagram for explaining an example of a positional relationship between the wiring portion 52, the conductor GND1, and the power module IPM1. In Fig. 4, the components other than these three are not necessary for the description, and are therefore omitted. In the example of Fig. 4, the power module IPM1 does not face any of the wiring portion 52 and the conductor GND1 in the thickness direction D11. The wiring portion 52 does not face any of the power module IPM1 and the conductor GND1 in the thickness direction D11. However, even in this case, the conductor GND1 is provided between the wiring portion 52 and the power module IPM1. For example, the conductor GND1 is positioned on a straight line B connecting the wiring portion 52 and the power module IPM1. Accordingly, noise propagating from power module IPM1 to wiring portion 52 can be suppressed.

However, according to this structure, the noise from the power module IPM1 may propagate along the thickness direction D11 to another wire (for example, a wire (not shown) provided in the inner wiring layer 22b in Fig. 2), and the noise may propagate from that wire to the wiring portion 52. Therefore, the configuration of Fig. 2 is superior in terms of suppressing noise propagation.

In the example of Fig. 2, both of the detection wires SL1 and SL2 pass through the inner wiring layer 22b. However, a case where one of the detection wires SL1 and SL2 passes through the inner wiring layer 22b, and the other one of the detection wires SL1 and SL2 passes through the outer wiring layer 21b is also permitted. Also in this case, the wiring portion of the other one of the detection wires SL1 and SL2 formed in the outer wiring layer 21b is formed such that the conductor GND1 is positioned between the wiring portion and the power module IPM1.

When one of the detection wires SL1 and SL2 is grounded, the one may be connected to the conductor GND1. In this case, the one does not need to pass through the inner wiring layer 22b.

In the above-described example, although the multilayer board 1 is a four-layer board, it is only required that the multilayer board 1 has at least three wiring layers. This is because, by having three wiring layers, the wiring portion 52, the conductor GND1, and the power module IPM1 can be formed in different layers from each other in a manner that the conductor GND1 is positioned between the wiring portion 52 and the power module IPM1.

Further, although the power module IPM1 includes a three-phase inverter, the number of phases may be determined according to the load M1. Further, the power module IPM1 does not necessarily have to include an inverter, and may have a power conversion circuit such as a switching regulator.

### <Conductor GND2>

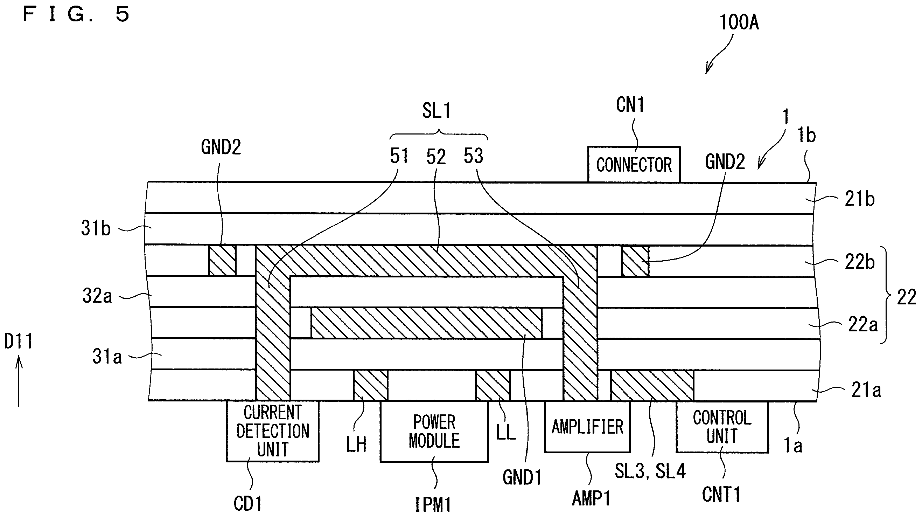

Fig. 5 is a diagram schematically showing an example of a configuration of a current detection device 100A. The current detection device 100A differs from the current detection device 100 in that there is provided a conductor GND2. The conductor GND2 is formed in the inner wiring layer 22b where the wiring portions 52 of the detection wires SL1 and SL2 are formed, and a fixed potential (for example, a ground potential) is applied similarly to the conductor GND1. The fixed potential applied to the conductors GND1 and GND2 may be different from each other. The conductor GND2 is formed in the inner wiring layer 22b so as to be adjacent to the wiring portions 52 of the detection wires SL1 and SL2. More specifically, the conductor GND2 is adjacent to at least a part of the wiring portion 52 without interposing another wire. The conductor GND2 may, for example, surround a pair of the wiring portions 52 of the detection wires SL1 and SL2 in plan view.

According to this, noise from another wire formed in the inner wiring layer 22b is shielded by the conductor GND2, and accordingly, the noise hardly enters the wiring portion 52. Therefore, the conductor GND2 contributes to inputting a detection signal with lower noise to the amplifier AMP1, and consequently to the control unit CNT1.

### <Material of insulating layer>

The multilayer board 1 described below does not necessarily have the above-described configuration, but is described using a specific example described above as a typical example.

The multilayer board 1 has four or more wiring layers. Any of comparative tracking indices (CTI: comparative tracking index) of the outer insulating layers 31a and 31b is higher than a comparative tracking index of the inner insulating layer 32a. For example, the comparative tracking indices of the outer insulating layers 31a and 31b are 1600 or more, and the comparative tracking index of the inner insulating layer 32a is 175 or more and is smaller than any of the comparative tracking indices of the outer insulating layers 31a and 31b. As material of the inner insulating layer 32a, for example, a glass fabric base epoxy resin can be adopted, and as material of the outer insulating layers 31a and 31b, for example, a glass fabric base epoxy resin can be adopted. Even in a case of using the glass fabric base epoxy resin, the comparative tracking indices of the inner insulating layer 32 and the outer insulating layers 31a and 31b can be changed by changing a composition ratio (for example, a mass ratio of epoxy to the whole) of the glass fabric base epoxy resin. Alternatively, the material different from that of the inner insulating layer 32 may be used for the outer insulating layers 31a and 31b.

In the multilayer board 1 as such, because the comparative tracking indices of the outer insulating layers 31a and 31b are higher than the comparative tracking index of the inner insulating layer 32a, the manufacturing cost can be reduced as compared with the case of using the material having a high comparative tracking index for all of the insulating layers.

The above example described the four-layer board, however, a board having five or more layers may be used. That is, the inner wiring layer set 22 may have three or more inner wiring layers 22a, 22b, ... In this case, the inner insulating layers are arranged between the N layers (N is an integer of 3 or more) of inner wiring layers 22a, 22b, ... That is, the (N-1) layers of inner insulating layers 32a, 32b, ... are arranged. In this case, the comparative tracking index of the outer insulating layer 31a is set higher than any of the comparative tracking indices of the (N-1) layers of inner insulating layers 32a, 32b, ..., and the comparative tracking index of the outer insulating layer 31b is set higher than any of the comparison tracking indices of the (N-1) inner insulating layers 32a, 32b, ...

### <Low-voltage and high voltage>

For example, the above multilayer board 1 includes the outer wiring layers 21a and 21b having wires for high voltage, and the inner wiring layers 22a and 22b only having wires for low-voltage. In other words, the maximum value of a voltage applied to the wires of the outer wiring layer 21a is larger than the maximum value of a voltage applied to the wires of the inner wiring layers 22a and 22b, and the maximum value of a voltage applied to the wires of the outer wiring layer 21b is larger than the maximum value of a voltage applied to the wires of the inner wiring layers 22a and 22b. Hereinafter, a specific example is described.

Examples of the wires for high voltage include the DC power source lines LH and LL, and the output lines Lu, Lv, and Lw, to which a voltage of about several hundred volts is applied. The DC power source lines LH and LL, and the output lines Lu, Lv, and Lw are arranged in the outer wiring layers 21a and 21b, but not in the inner wiring layers 22a and 22b.

Examples of the wires for low-voltage include detection wires SL1 and SL2 to which a voltage of, for example, about several volts is applied. In the example of Fig. 2, the detection wires SL1 and SL2 are arranged in the outer wiring layer 21a and the inner wiring layer 22b.

Examples of the wires for low-voltage include, as well as the detection wires SL1 and SL2, the detection wires SL3 and SL4, and wires (not shown) for supplying power source to the control unit CNT1 or the amplifier AMP1. The voltage applied to the above wires is about over ten volts or less. The above wires may be appropriately arranged in the outer wiring layers 21a and 21b, and the inner wiring layers 22a and 22b.

Because only the wires low-voltage are formed in the inner wiring layer 22b, the voltage applied between the wires (for example, the detection wires SL1 and SL2) in the inner wiring layer 22b is low. Therefore, even when the comparative tracking index of the inner insulating layer 32a is low, tracking does not easily occur in the inner insulating layer 32a between the wires in the inner wiring layer 22b.

Similarly, because only the wires for low-voltage are formed in the inner wiring layer 22a, the voltage applied between the wires in the inner wiring layer 22a is also low. Therefore, even when the comparative tracking index of the inner insulating layer 32a is low, tracking does not easily occur also in the inner insulating layer 32a between the wires in the inner wiring layer 22a.

As described above, it is suitable to form only the wires for low-voltage in the inner wiring layers 22a and 22b, for the multilayer board 1 in which the inner insulating layer 32a has a low comparative tracking index and the outer insulating layers 31a and 31b have high comparative tracking indices.

When the inner wiring layer set 22 has N layers of inner wiring layers, only the wires for low-voltage may be arranged in the N layers of inner wiring layers.

### <Gap between wires>

In the multilayer board 1, the minimum value of a gap between the wires (gap between patterns) formed in the outer wiring layer 21a may be smaller than the minimum value of a gap between the wires (distance between patterns) formed in each of the inner wiring layers 22a and 22b. For example, the minimum value of the gap between the wires formed in the outer wiring layer 21a is 0.15 mm, and the minimum value of the gap between the wires formed in each of the inner wiring layers 22a and 22b is 0.25 mm. The minimum value of a width of the wires formed on the outer wiring layer 21a is 0.15 mm, and the minimum value of a width of the wires formed on each of the inner wiring layers 22a and 22b is 0.5 mm. The same applies to the outer wiring layer 21b.

Because a dielectric constant tends to decrease as the comparative tracking index increases, the dielectric constant of the outer insulating layer 31a is lower than that of the inner insulating layer 32a. Therefore, even if the gap between the wires formed in the outer wiring layer 21a is small, a decrease in impedance between the wires can be suppressed. The same applies to the outer wiring layer 21b. Conversely, even when the dielectric constant of the inner insulating layer 32a is low, a decrease in impedance between the wires can be suppressed by widening the gap between the wires formed in the inner wiring layers 22a and 22b. By adopting the above size relationship between the gaps, the propagation of noise between the respective wires of the outer wiring layers 21a and 21b, and the inner wiring layers 22a and 22b can be suppressed.

As described above, it is suitable to set the minimum value of the gaps between the respective wires of the outer wiring layers 21a and 21b smaller than both of the minimum values of the gaps between the respective wires of the inner wiring layers 22a and 22b, for the multilayer board 1 in which the inner insulating layer 32a has a low comparative tracking index and the outer insulating layers 31a and 31b have high comparative tracking indices.

When the inner wiring layer set 22 has N layers of inner wiring layers, the minimum value of the gaps between the respective wires of the outer wiring layers 21a and 21b is set to be smaller than any minimum values of the gaps between the respective wires of the N layers of inner wiring layers.

Although the embodiment has been described above, it will be understood that various changes in form and details can be made without departing from the scope of the claims. Further, the various examples and modifications described above can be combined with each other.

Although embodiments of the present invention have been described in detail, the above description is illustrative in all aspects, and the present invention is not limited thereto. It is understood that countless modifications that are not illustrated can be envisaged without departing from the scope of the present invention as claimed.

## Claims

1. A current detection device (100) comprising:
a multilayer board (1) including a first surface (1a) provided for mounting a power module (IPM1), the power module having switching elements (S1 to S6), the multilayer board further including a second surface (1b) on an opposite side of the multilayer board to the first surface, a first wiring layer (21a) in the first surface, a second wiring layer (22a) arranged on a side nearer to the second surface than the first wiring layer, a third wiring layer (22b) arranged on the side nearer to the second surface than the second wiring layer;
a current detection unit (CD1) that is mounted on the first surface, for detecting a current flowing through the power module, and for outputting a detection signal; and
a control unit (CNT1) that is mounted on the first surface and for receiving the detection signal,
**characterized by** further comprising:
a detection wire (SL1, SL2) for transmitting the detection signal from the current detection unit to the control unit, and having a first wiring portion (51) extending from the current detection unit to the third wiring layer, a second wiring portion (52) connected to the first wiring portion and formed in the third wiring layer, and a third wiring portion (53) connected to the second wiring portion and extending from the third wiring layer to the control unit; and
a first conductor (GND1) arranged in the second wiring layer between the second wiring portion of the detection wire and the power module, and applied with a fixed potential,
the multilayer board further including:
a fourth wiring layer (21b) in the second surface;
a first insulating layer (31a) arranged between a set (22) of inner wiring layers and the first wiring layer, the set being positioned between the first wiring layer and the fourth wiring layer, the set including the second wiring layer and the third wiring layer;
at least one second insulating layer (32a) arranged between adjacent ones of the inner wiring layers; and
a third insulating layer (31b) arranged between the set and the fourth wiring layer, configured such that,
a comparative tracking index of the first insulating layer is higher than a comparative tracking index of any of the second insulating layers, and
a comparative tracking index of the third insulating layer is higher than the comparative tracking index of any of the second insulating layers.

2. The current detection device according to claim 1, configured such that, the first conductor (GND1) faces either or both of the second wiring portion (52) of the detection wire (SL1, SL2) and the power module (IPM1), in a thickness direction (D11) of the multilayer board (1).

3. The current detection device according to claim 2, configured such that, the power module (IPM1) is positioned in the first surface (1a) of the multilayer board (1) between the current detection unit (CD1) and the control unit (CNT1).

4. The current detection device according to any one of claims 1 to 3, further comprising a second conductor (GND2) formed at a position in the third wiring layer (22b) adjacent to the second wiring portion (52) of the detection wire (SL1, SL2) without interposing another wire, and applied with a fixed potential.

5. The current detection device according to any one of claims 1 to 4, configured such that, a maximum value of a voltage applied to wires formed in the first wiring layer and a maximum value of a voltage applied to wires formed in the fourth wiring layer are larger than a maximum value of a voltage applied to wires formed in any of the inner wiring layers.

6. The current detection device according to any one of claims 1 to 4, configured such that a minimum value of a gap between wires formed in the first wiring layer and a minimum value of a gap between wires formed in the fourth wiring layer are smaller than a minimum value of a gap between wires formed in any of the inner wiring layers.

## Patentansprüche

1. Stromdetektionsvorrichtung (100), umfassend:
eine mehrschichtige Leiterplatte (1), einschließlich einer zum Montieren eines Leistungsmoduls (IPM1) bereitgestellten ersten Oberfläche (1a), wobei das Leistungsmodul Schaltelemente (S1 bis S6) aufweist, wobei die mehrschichtige Leiterplatte weiter eine zweite Oberfläche (1b) auf einer zu der ersten Oberfläche gegenüberliegenden Seite der mehrschichtigen Leiterplatte, eine erste Verdrahtungsschicht (21a) in der ersten Oberfläche, eine zweite Verdrahtungsschicht (22a), die auf einer Seite näher an der zweiten Oberfläche angeordnet ist als die erste Verdrahtungsschicht, eine dritte Verdrahtungsschicht (22b), die auf der Seite näher zu der zweiten Oberfläche angeordnet ist als die zweite Verdrahtungsschicht, einschließt;
eine Stromdetektionseinheit (CD1), die auf der ersten Oberfläche montiert ist, zum Detektieren eines durch das Leistungsmodul fließenden Stroms und zum Ausgeben eines Detektionssignals; und
eine Steuereinheit (CNT1), die auf der ersten Oberfläche und zum Empfangen des Detektionssignals montiert ist,
**dadurch gekennzeichnet, dass** sie weiter Folgendes umfasst:
einen Detektionsdraht (SL1, SL2) zum Übertragen des Detektionssignals von der Stromdetektionseinheit an die Steuereinheit und einen ersten Verdrahtungsabschnitt (51) aufweisend, der sich von der Stromdetektionseinheit zu der dritten Verdrahtungsschicht erstreckt, einen mit dem ersten Verdrahtungsabschnitt verbundenen und in der dritten Verdrahtungsschicht gebildeten zweiten Verdrahtungsabschnitt (52), und einen mit dem zweiten Verdrahtungsabschnitt verbundenen und sich von der dritten Verdrahtungsschicht zu der Steuereinheit erstreckenden dritten Verdrahtungsabschnitt (53); und
einen in der zweiten Verdrahtungsschicht zwischen dem zweiten Verdrahtungsabschnitt des Detektionsdrahts und dem Leistungsmodul, und angelegt mit einem festen Potential, angeordneten ersten Leiter (GND1),
wobei die mehrschichtige Leiterplatte weiter einschließt:
eine vierte Verdrahtungsschicht (21b) in der zweiten Oberfläche;
eine zwischen einem Satz (22) von inneren Verdrahtungsschichten und der ersten Verdrahtungsschicht angeordnete erste Isolierschicht (31a), wobei der Satz zwischen der ersten Verdrahtungsschicht und der vierten Verdrahtungsschicht positioniert ist, wobei der Satz die zweite Verdrahtungsschicht und die dritte Verdrahtungsschicht einschließt;
mindestens eine zwischen angrenzenden der inneren Verdrahtungsschichten angeordnete zweite Isolierschicht (32a); und
eine zwischen dem Satz und der vierten Verdrahtungsschicht angeordnete dritte Isolierschicht (31b), so konfiguriert, dass
eine Vergleichszahl der Kriechwegbildung der ersten Isolierschicht höher als eine Vergleichszahl der Kriechwegbildung von beliebigen der zweiten Isolierschichten ist, und
eine Vergleichszahl der Kriechwegbildung der dritten Isolierschicht höher als die Vergleichszahl der Kriechwegbildung von beliebigen der zweiten Isolierschichten ist.

2. Stromdetektionsvorrichtung nach Anspruch 1, so konfiguriert, dass der erste Leiter (GND1) in einer Dickenrichtung (D11) der mehrschichtigen Leiterplatte (1) einem oder beiden des zweiten Verdrahtungsabschnitts (52) des Detektionsdrahts (SL1, SL2) und des Leistungsmoduls (IPM1) zugewandt ist.

3. Stromdetektionsvorrichtung nach Anspruch 2, so konfiguriert, dass das Leistungsmodul (IPM1) in der ersten Oberfläche (1a) der mehrschichtigen Leiterplatte (1) zwischen der Stromdetektionseinheit (CD1) und der Steuereinheit (CNT1) positioniert ist.

4. Stromdetektionsvorrichtung nach einem der Ansprüche 1 bis 3, weiter umfassend einen zweiten Leiter (GND2), der an einer Position in der dritten Verdrahtungsschicht (22b) angrenzend an den zweiten Verdrahtungsabschnitt (52) des Detektionsdrahts (SL1, SL2), ohne einen anderen Draht einzufügen, und angelegt mit einem festen Potential, gebildet ist.

5. Stromdetektionsvorrichtung nach einem der Ansprüche 1 bis 4, so konfiguriert, dass ein maximaler Wert einer an in der ersten Verdrahtungsschicht gebildeten Drähten angelegten Spannung und ein maximaler Wert einer an in der vierten Verdrahtungsschicht gebildeten Drähten angelegten Spannung größer sind als ein maximaler Wert einer an in beliebigen der inneren Verdrahtungsschichten gebildeten Drähten angelegten Spannung.

6. Stromdetektionsvorrichtung nach einem der Ansprüche 1 bis 4, so konfiguriert, dass ein minimaler Wert eines Spalts zwischen in der ersten Verdrahtungsschicht gebildeten Drähten und ein minimaler Wert eines Spalts zwischen in der vierten Verdrahtungsschicht gebildeten Drähten kleiner sind als ein minimaler Wert eines Spalts zwischen in beliebigen der inneren Verdrahtungsschichten gebildeten Drähten.

## Revendications

1. Dispositif de détection de courant (100) comprenant :
une carte multicouche (1) incluant une première surface (1a) fournie pour monter un module d'alimentation (IPM1), le module d'alimentation présentant des éléments de commutation (S1 à S6), la carte multicouche incluant en outre une seconde surface (1b) sur un côté opposé de la carte multicouche à la première surface, une première couche de câblage (21a) dans la première surface, une deuxième couche de câblage (22a) agencée sur un côté plus proche de la seconde surface que la première couche de câblage, une troisième couche de câblage (22b) agencée sur le côté plus proche de la seconde surface que la deuxième couche de câblage ;
une unité de détection de courant (CD1) qui est montée sur la première surface, pour détecter un courant circulant à travers le module d'alimentation, et pour délivrer un signal de détection ; et
une unité de commande (CNT1) qui est montée sur la première surface et pour recevoir le signal de détection,
**caractérisé en ce qu'**il comprend en outre :
un fil de détection (SL1, SL2) pour transmettre le signal de détection depuis l'unité de détection de courant vers l'unité de commande, et présentant une première partie de câblage (51) s'étendant à partir de l'unité de détection de courant vers la troisième couche de câblage, une deuxième partie de câblage (52) connectée à la première partie de câblage et formée dans la troisième couche de câblage, et une troisième partie de câblage (53) connectée à la deuxième partie de câblage et s'étendant à partir de la troisième couche de câblage vers l'unité de commande ; et
un premier conducteur (GND1) agencé dans la deuxième couche de câblage entre la deuxième partie de câblage du fil de détection et le module d'alimentation, et auquel est appliqué un potentiel fixe,
la carte multicouche incluant en outre :
une quatrième couche de câblage (21b) dans la seconde surface ;
une première couche isolante (31a) agencée entre un ensemble (22) de couches de câblage interne et la première couche de câblage, l'ensemble étant positionné entre la première couche de câblage et la quatrième couche de câblage, l'ensemble incluant la deuxième couche de câblage et la troisième couche de câblage ;
au moins une deuxième couche isolante (32a) agencée entre des couches adjacentes des couches de câblage interne ; et
une troisième couche isolante (31b) agencée entre l'ensemble et la quatrième couche de câblage, configurée de telle sorte que,
un indice de suivi comparatif de la première couche isolante est supérieur à un indice de suivi comparatif de l'une quelconque des deuxièmes couches isolantes, et
un indice de suivi comparatif de la troisième couche isolante est supérieur à l'indice de suivi comparatif de l'une quelconque des deuxièmes couches isolantes.

2. Dispositif de détection de courant selon la revendication 1, configuré de telle sorte que le premier conducteur (GND1) fait face à l'un ou aux deux parmi la deuxième partie de câblage (52) du fil de détection (SL1, SL2) et le module d'alimentation (IPM1), dans une direction d'épaisseur (D11) de la carte multicouche (1).

3. Dispositif de détection de courant selon la revendication 2, configuré de telle sorte que le module d'alimentation (IPM1) est positionné dans la première surface (1a) de la carte multicouche (1) entre l'unité de détection de courant (CD1) et l'unité de commande (CNT1) .

4. Dispositif de détection de courant selon l'une quelconque des revendications 1 à 3, comprenant en outre un second conducteur (GND2) formé à une position dans la troisième couche de câblage (22b) adjacente à la deuxième partie de câblage (52) du fil de détection (SL1, SL2) sans interposer un autre fil, et auquel est appliqué un potentiel fixe.

5. Dispositif de détection de courant selon l'une quelconque des revendications 1 à 4, configuré de telle sorte qu'une valeur maximale d'une tension appliquée aux fils formés dans la première couche de câblage et une valeur maximale d'une tension appliquée aux fils formés dans la quatrième couche de câblage sont supérieures à une valeur maximale d'une tension appliquée aux fils formés dans l'une quelconque des couches de câblage interne.

6. Dispositif de détection de courant selon l'une quelconque des revendications 1 à 4, configuré de telle sorte qu'une valeur minimale d'un intervalle entre des fils formés dans la première couche de câblage et une valeur minimale d'un intervalle entre des fils formés dans la quatrième couche de câblage sont inférieures à une valeur minimale d'un intervalle entre des fils formés dans l'une quelconque des couches de câblage interne.
